# EUROPEAN PATENT SPECIFICATION

(11) **EP 1 689 005 B1**
(45) Date of publication and mention of the grant of the patent: **21.04.2010**
(21) Application number: 05002610.3
(22) Date of filing: 08.02.2005
(51) Int. Cl.: H01L 41/053, F02M 51/06, F02M 61/16

(54) **Actuator unit and fluid injector**
Stelleinrichtung und Flüssigkeitseinspritzventil
Dispositif de réglage et injecteur de fluide

(43) Date of publication of application: 09.08.2006
(73) Proprietor: Continental Automotive Italy S.p.A., 56040 Fauglia (PI) (IT)
(72) Inventor: Fischetti, Gianbattista, 56000 Pisa (IT); Zanoboni, Cristiano, 57016 Rosignano Solvay (LI) (IT)
(74) Representative: Bonn, Roman Klemens

(56) References cited:
- WO-A-00/08353
- DE-A1- 19 744 235
- DE-C1- 19 854 508
- US-B1- 6 172 445

## Description

The invention relates to an actuator unit with a tube spring and a piezoelectric actuator, that is inserted into the tube spring and is pretensioned by the tube spring.

Actuator units with a piezoelectric actuator are in widespread use and are increasingly used for fuel injectors for internal combustion engines. They have the advantage of having a very fast response time to actuating signals and therefore enable multiple injections into a cylinder of the internal combustion engine during one working cycle of the cylinder.

WO 00/08353 discloses an actuator unit with a tube spring, a piezoelectric actuator that is inserted into the tube spring, a first cap that is connected to the tube spring at a first free end of the tube spring and which is adjoined by the piezoelectric actuator, and a second cap that is connected to the tube spring at a second free end of the tube spring and which is also adjoined by the piezoelectric actuator. The first and second caps are welded to the tube spring. The tube spring is preferably made out of steel and has recesses that are formed in a bone-shaped manner. The piezoelectric actuator is pretensioned by the tube spring. The pretension forces are transmitted to the piezoelectric actuator by the first and second cap. When a voltage is applied to the actuator unit, the actuator unit changes its axial length. If it is used, for example, for a fuel injector it is inserted into a housing of the fuel injector and is contacted on one of its caps by a first element and is contacted on the second cap by a second element, which is for example a needle of the injection valve. If a voltage is applied to the actuator unit it lengthens and in that way acts on the second element and moves it respectively. In order to ensure a precise operation the surface of the first and second caps, which contact the first or respectively the second element need to be precisely rectangular to enable a good guide for the actuator unit. In addition to that also the respective surfaces of the first and the second element need to be manufactured precisely in order to ensure a good contact between the caps and the first or respectively the second element and to enable a good guide of the actuator unit. Up to now this has been achieved by a special flat grinding operation.

US 6 172 445 B1 discloses a fluid injector with an actuator comprising a piezoelectric body, which is provided on one end face with a face-end concave plate and on its other end with a plate which is on its side remote from a body and a has a tappet-like extension. Motions of the piezoelectric body are transmitted to a tappet causing the tappet to open or close a control valve via the tappet-like extension.

The object of the invention is to create an actuator unit, which is simple and at the same time is of high quality.

This object is achieved by the features of the independent claims. Advantageous embodiments of the invention are given in the subclaims.

The invention is in accordance with a first aspect distinguished by an actuator unit with a tube spring, a piezoelectric actuator, that is inserted into the tube spring and a first cap, that is connected to the tube spring at the free end of the tube spring and having a recess, into which a needle is fitted. Further the actuator unit comprises a contact disk, that is inserted into the tube spring and which is on the first free end adjoined by the piezoelectric actuator and on the second free end adjoined by the first cap and the needle. The use of the contact disk makes it possible to reduce the length of the actuator unit. The components are easier to manufacture, because the first cap does not need, for example a chromium plating, for a hard surface. The contact disk is precisely formed and a high quality contact to the elements is ensured because of the same surface.

In an advantageous embodiment of the actuator unit the contact disk is made out of a harder material than the first cap. The use of the contact disk being made out of a harder material than the first cap ensures a higher capacity of resistance to wear.

In a further advantageous embodiment of the actuator unit the contact disk is made out of hard steel. Such a material is widely and fairly cheaply available and very wear resistant.

The invention is in accordance with a second aspect distinguished by a fluid injector, that comprises a housing, a valve body and an actuator unit. A needle is placed in the housing and the valve body. In the closing position the needle stops any fluid stream through an injection nozzle. In any other position the fluid stream through the injection nozzle is possible. Such a fluid injector has the advantage, that the fluid stream through the injection nozzle is extremely precise and can be safely controlled

Exemplary embodiments of the invention are explained in the following with the aid of schematic drawings. These are as follows:

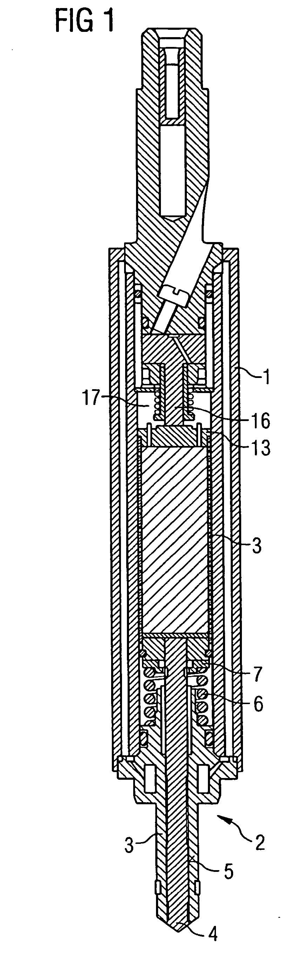

Figure 1, a fuel injector with an actuator unit and
Figure 2, a cut-out of the actuator unit.

Elements of the same design and function that occur in different illustrations are identified by the same reference character.

A fluid injector, that is embodied as a fuel injector, that is suitable for injecting fuel into a gasoline engine or that also may be suitable for injecting fuel into a diesel engine, comprises a housing 1, a valve body 2 and an actuator unit 8. The fuel injector is preferably located in a cylinder head of an internal combustion engine and provides a combustion chamber with fuel. The housing may be double tube-shaped. In the space between the walls of the double tube the fuel may be lead to the valve body 2. However fuel may also be lead in another way to the valve body 2.

The valve body 2 comprises a cartridge 3 with a recess and a needle 4 that is inserted into the recess and is guided in the arrow of a guide 5. The needle 4 is of an outward-opening type, but it may also be of an inward-opening type. The needle 4 is pushed in its closed position by a return spring 6, which rests on a spring washer 7, that is connected to the needle 4. The return spring 6 exerts a force on the needle 4 in the closing direction of the needle 4.

The actuator unit 8 is inserted into an inner tube 17 of the housing 1. The actuator unit is contacted on one of its axial ends by a first element that is embodied as a thermal compensator 16 and on its other axial end contacts a second element that is embodied as the needle 4. Depending on actuating signals the actuator unit 8 changes it axial length and in that way pushes the needle 4 in its open position or leaves it in its closed position.

The actuator unit 8 comprises a piezo actuator 9 that is inserted into a tube spring 10 which pretensions the piezo actuator with a given force, for example 15 Newton. The tube spring 10 is preferably made out of steel and comprises various recesses, that are formed in a bone-shaped manner. The tube spring needs to be made of a material and to be formed in a way that it can uphold the pretension and is also flexible enough for the further axial lengthening of the piezo actuator 9. The actuator unit 8 further comprises a second cap 13, that is joined to the tube spring 10 at a free end of the tube spring 10. The second cap 13 has holes in which contact pins 20 are inserted and are electrically contacted to the electrodes of the piezo elements of the piezo actuator 9. The piezo actuator 9 comprises a stack of piezo elements. The second cap 13 is preferably welded to the tube spring 10 at the first free end. It is preferably laser-welded.

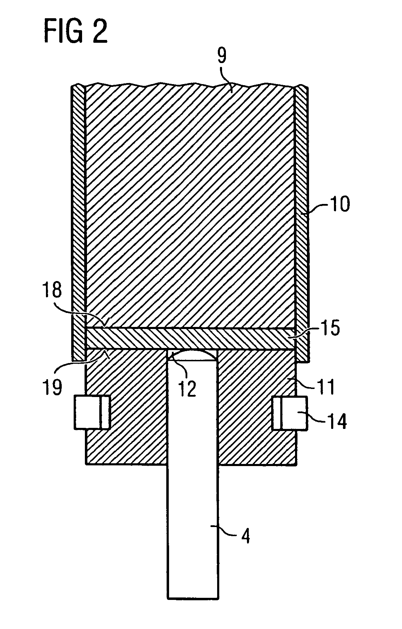

The actuator unit 8 (Figure 2) further comprises a first cap 11, that is joined to the tube spring 10 at the other free end of the tube spring 10. The first cap 11 has a recess 12, that is preferably formed as a bore into which the needle 4 is fitted. The first cap 11 further comprises a guide ring 14. The guide ring 14 guides the actuator unit 8 in the inner tube 17.

The actuator unit 8 further comprises a contact disk 15, that is inserted into the tube spring 10 and which is on the first free end 18 adjoined by the piezoelectric actuator 9 and on the second free end 19 adjoined by the first cap 11 and the needle 4. The contact disk 15 is preferably made out of a harder material than the first cap 11. The contact disk 15 is preferably made out of hard steel, for example AISI440C. The contact disk 15 is just inserted in the tube spring and not joined with the tube spring 10. The needle 4 is freely moveable in the recess 12 of the first cap 11. The first cap 11 is joined to the tube spring 10 preferably by a welding process. It is preferably laser-welded. In addition to that the material of the first cap 11 and the second cap 13 can be chosen to be most suited for a welding, especially for a laser-welding process, and the material of the contact disk may be chosen to ensure a high level of resistance to wear. In that way an expensive hardening treatment of an otherwise existing contacting area of the second cap 13 does not need to be made.

## Claims

1. Actuator unit with
- a tube spring (10),
- a piezoelectric actuator (9), that is inserted into the tube spring (10),
- a first cap (11), that is connected to the tube spring (10) at a free end of the tube spring (10) and having a recess (12), **characterized in that**
- a needle (4) is fitted into the recess (12),
- a contact disc(15) is inserted into the tube spring (10) and which is on the first free end (18) adjoined by the piezoelectric actuator (9)and on the second free end (19) adjoined by the first cap (11) and the needle(4).

2. Actuator unit in accordance with claim 1 with the contact disc (15) being made out of a harder material than the first cap(11).

3. Actuator unit in accordance with claim 2 with the contact disc (15) being made out of hard steel.

4. Fluid injector with a housing (1) and an actuator unit in accordance with one of the preceding claims.

## Patentansprüche

1. Stellgliedeinheit mit
einer Rohrfeder (10),
einem piezoelektrischen Stellglied (9), das in die Rohrfeder (10) eingesetzt ist,
eine erste Abdeckung (11), die mit der Rohrfeder (10) an einem freien Ende der Rohrfeder (10) verbunden ist und die eine Aussparung (12) aufweist, **dadurch gekennzeichnet, dass** eine Nadel (4) an die Aussparung (12) angepasst ist und
eine Kontaktscheibe (15) in die Rohrfeder (10) eingesetzt ist und an dem ersten freien Ende (18) benachbart zu dem piezoelektrische Stellglied (9) und an dem zweiten freien Ende (19) benachbart zu der ersten Abdeckung (11) und der Nadel (4) angeordnet ist.

2. Stellgliedeinheit gemäß Anspruch 1, während die Kontaktscheibe (15) aus einem härteren Material als die erste Abdeckung (11) hergestellt ist.

3. Stellgliedeinheit gemäß Anspruch 2, während die Kontaktscheibe (15) aus einem harten Stahl hergestellt ist.

4. Fluidinjektor mit einem Gehäuse (1) und einer Stellgliedeinheit gemäß einem der vorhergehenden Ansprüche.

## Revendications

1. Unité d'actionneur comprenant :
- un ressort tubulaire (10),
- un actionneur piézoélectrique (9), qui est inséré dans le ressort tubulaire (10),
- un premier capuchon (11), qui est relié au ressort tubulaire (10) au niveau d'une extrémité libre du ressort tubulaire (10) et qui présente une cavité (12), **caractérisée en ce que :**
- une aiguille (4) est insérée dans la cavité (12),
- un disque de contact (15) est inséré dans le ressort tubulaire (10), qui se situe sur la première extrémité libre (18) attenante au dispositif d'actionneur piézoélectrique (9) et sur la deuxième extrémité libre (19) attenante au premier capuchon (11) et l'aiguille (4).

2. Unité d'actionneur selon la revendication 1, dans laquelle le disque de contact (15) est réalisé dans un matériau plus dur que celui du premier capuchon (11).

3. Unité d'actionneur selon la revendication 2, dans laquelle le disque de contact (15) est réalisé en acier dur.

4. Injecteur de fluide comprenant un logement (1) et une unité d'actionneur selon l'une quelconque des revendications précédentes.
